# EUROPEAN PATENT SPECIFICATION

(11) **EP 1 516 031 B1**
(45) Date of publication and mention of the grant of the patent: **15.08.2007**
(21) Application number: 03761250.4
(22) Date of filing: 23.06.2003
(51) Int. Cl.: C09J 163/00, H01L 21/00, C09J 11/00

(54) **HEAT CURABLE ADHESIVE COMPOSITION, ARTICLE, SEMICONDUCTOR APPARATUS AND METHOD**
WÄRMEHÄRTBARE KLEBSTOFFZUSAMMENSETZUNG, GEGENSTAND, HALBLEITERVORRICHTUNG UND VERFAHREN
COMPOSITION ADHESIVE THERMODURCISSABLE, ARTICLE, DISPOSITIF A SEMI-CONDUCTEUR ET PROCEDE

(30) Priority: 24.06.2002 JP 2002183277; 12.09.2002 JP 2002267115
(43) Date of publication of application: 23.03.2005
(73) Proprietor: 3M Innovative Properties Company, St. Paul, MN 55133-3427 (US)
(72) Inventor: TAKEUCHI, Shoji, Sagamihara, Kanagawa 229-0032 (JP); KAWATE, Kohichiro, Machida, Tokyo 194-0041 (JP); SAKAKIBARA, Makoto, Hachioji, Tokyo 193-0321 (JP)
(74) Representative: Vossius & Partner
(86) International application number: PCT/US2003/019712
(87) International publication number: WO 2004/000966

(56) References cited:
- EP-A- 1 167 483
- US-A- 4 521 570
- PATENT ABSTRACTS OF JAPAN vol. 2002, no. 09, 4 September 2002 (2002-09-04) & JP 2002 146319 A (THREE M INNOVATIVE PROPERTIES CO), 22 May 2002 (2002-05-22) cited in the application

## Description

The present invention relates to a heat curable adhesive composition, a process for preparing the game, and an adhesive article, that is, a backing material having the heat curable adhesive composition thereon. The present invention also relates to a semiconductor apparatus and a method for preparing it using such an adhesive film or adhesive article.

As is well known, an epoxy resin is one example of heat curable resins having excellent adhesive strength. Therefore, the epoxy resin is widely used as a main component of heat curable adhesive compositions.

When a heat curable adhesive composition includes a typical epoxy resin, it generally exhibits its adhesive strength only after it is hardened by heat curing, and has only low adhesive strength before heat curing. In other words, usually such a heat curable adhesive composition has substantially no initial adhesive strength before hardening by application of heat.

It is important for a heat curable adhesive composition to have some initial adhesive strength, especially in the process of manufacturing a semiconductor apparatus. This is because, in the process of manufacturing a semiconductor apparatus, usually there is a process of cutting a semiconductor wafer into a desired size (called a dicing process) after an IC (integrated circuit), LSI (large scale integration), or the like is formed on a semiconductor wafer such as a silicon wafer using a lithographic technique, an etching technique or the like.

In a dicing process, in general, the semiconductor wafer such as a silicon wafer is fixed using an adhesive tape containing adhesive polymer (sometimes called a "dicing tape"), in order to retain the individual semiconductor chips which have been formed in the dicing process. Thus, the dicing tape is required to have sufficient pressure-sensitive adhesiveness or adhesive strength ("initial adhesive strength" as used herein) to stabilize and hold the semiconductor chips. If the dicing tape has such an excellent initial adhesive strength, the dicing tape can be used as it is in the die bonding process as a die bonding tape for fixing the semiconductor chip to a substrate, so that smooth transition from the dicing process to the die bonding process can be realized efficiently.

Enhancing initial adhesive strength of adhesive articles has been attempted previously although it is not specifically intended to be applied to particular adhesive tapes such as dicing tapes. For example, a method for manufacturing a heat curable adhesive tape having variable adhesive strength, which includes a process of coating a peelable release film or substrate with a liquid mixture of substances containing a photopolymerizable compound, a heat curable epoxy resin or mixture of epoxy resins containing no photopolymerizable group, a heat activatable curing agent for the epoxy resins, an accelerator, and a photopolymerization catalyst is well-known (see, Japanese Unexamined Patent Publication (Kokai) No. 60-173076). Also, a pressure sensitive heat curable adhesive comprising a photopolymerizable monomeric syrup, an epoxy resin or a mixture of epoxy resins, heat activatable hardener for the epoxy resins, a photoinitiator, and a photocrosslinking agent is well-known (see, Japanese Unexamined Patent Publication (Kokai) No. 2-272076). The heat curable adhesive compositions disclosed in these references use epoxy resins in conjunction with a pressure sensitive adhesive to obtain the desired initial adhesive strength. However, in such heat curable adhesive compositions, problems inevitably arise such as deterioration of heat resistance or degradation of shear strength due to addition of a pressure-sensitive adhesive.

In view of preventing the degradation of heat resistance and shear strength, a heat curable adhesive composition without a pressure-sensitive adhesive has also been disclosed (see, T. Ashida, M. Ochi and K. Handa, J. Adhesion Sci. Technol., 12,749 (1988)). The heat curable adhesive composition disclosed in this publication is composed of an epoxy resin which has core/shell micro-particles of an ionomer dispersed therein. However, as is well known, an ionomer contains ionic components and may give rise to defects such as corrosion in a semiconductor chip or in underlying substrates.

In addition, in implementing the die bonding process, usually heat bonding of a semiconductor chip to a base via a heat curable adhesive composition is required. In view of production efficiency of semiconductor components and the investment cost of the manufacturing equipment, it is highly desirable to perform the heat bonding process at the lowest possible temperature and in the shortest possible time and to obtain high adhesive strength easily.

Also, it is required that, in the heat bonding process, the heat curable adhesive composition should not flow out in the surroundings of a semiconductor chip under the applied pressure, since such a contamination may give rise to a short circuit of electrical wirings in subsequent wire bonding or other processes, or may even hinder formation of the electrical wiring itself. Thus, although a typical epoxy resin which has generally high fluidity can be used for a general purpose heat curable adhesive composition without giving rise to any problem, it is substantially difficult to apply this epoxy resin to a heat curable adhesive composition intended to be used for manufacturing a semiconductor apparatus.

A heat curable adhesive composition comprising a caprolactone-modified epoxy resin, a curing agent for the epoxy resin and a phenoxy resin is known as a heat curable adhesive composition which can be heat bonded with a relatively low temperature for a short time (see Japanese Unexamined Patent Publication (Kokai) No. 2002-146319). It is shown that the adhesive composition exhibits a good initial adhesive strength and after curing, exhibits an excellent heat resistance.

In a recent tendency for improving a semiconductor's integration, a wafer often is grounded on the side having no logic circuit formed thereon (backside) to a thickness of 0.1 mm (100 micrometers) or less (used to be typically 0.4 mm (400 micrometers) or less), and a plurality of chips from such wafers are stacked in a so-called multi-chip package (MCP) in order to make the semiconductor apparatus more multi-functional, higher density and more compact.

For producing such structure, an important part of the process is a dicing step and a die bonding step of a thinned wafer. A wafer having a thickness of 0.1 mm or less is usually very brittle, and the possibility that the wafer breakage will increase as the thickness of the wafer is lowered. In handling a thinned wafer, a dicing tape, after being used, is required to have a sufficiently lowered pressure-sensitive adhesiveness or adhesive strength. If chips are released from a dicing tape due to such decreased adhesiveness, they can be incorporated into a package by easily picking up the chips using a pick-up rod in a subsequent packaging process.

For example, after wafer dicing if the pressure-sensitive adhesive polymer of the pressure-sensitive adhesive tape used as a dicing tape is highly cross-linked three-dimensionally as a result of being irradiated with energy rays such as heat or ultraviolet rays, its pressure-sensitive adhesive strength could be decreased, thereby enabling it to satisfy the above requirement. As disclosed in Japanese National Patent Publication (Kohyo) No. 56-500889 in particular, when a pressure-sensitive adhesive composition contains an adhesive polymer having epoxy groups and an ion photoinitiator such as an onium salt compound, although it initially adheres strongly to the adhered object, its adhesive strength is decreased when irradiated with light, thereby enabling it to be easily separated from the adhered object. This is because the above ion photoinitiator promotes an ionic ring-opening polymerization reaction of the epoxy groups of the pressure-sensitive adhesive polymer, thereby enabling effective three-dimensional cross-linking of the pressure-sensitive adhesive polymer.

In addition, by providing a pressure-sensitive adhesive tape with thermal expandability, the contact surface with the adhered object can be reduced thus facilitating separation from the adhered object. For example, Japanese Examined Patent Publication (Kokoku) No. 51-24534 discloses a pressure-sensitive adhesive tape that contains a thermal foaming agent. In addition, Japanese Unexamined Patent Publication (Kokai) Nos. 56-61467, 56-61468, 56-61469, 60-252681, 63-186791 and 2-305878 disclose a thermally expanding adhesive provided with thermally expanding microspheres. In particular, Japanese Unexamined Patent Publication (Kokai) Nos. 56-61467, 56-61468, 56-61469, 63-186791 and 2-305878 disclose the filling of thermally expanding hollow microspheres with a low boiling point compound (such as propane or butane) or a thermal degradation type of foaming agent (such as ammonium hydrogen carbonate or azobisisobutyronitrile). In addition, Japanese Unexamined Patent Publication (Kokai) No. 60-252681 discloses the use of thermally expanding microspheres referred to as "EXPANCELLS" (trade name). Moreover, Japanese Unexamined Patent Publication (Kokai) No. 63-30581 also discloses an adhesive strength dissipating type of pressure-sensitive adhesive that contains a photo-crosslinking agent, adhesive polymer or pressure-sensitive adhesive polymer and a foaming agent.

In the case of cross-linking an adhesive polymer or pressure-sensitive adhesive polymer with ultraviolet rays or other light, as described above, a light source for that purpose is additionally required. In addition, in the case of the pressure-sensitive adhesive sheet containing a foaming agent or using a thermally expanding adhesive, heat resistance tends to be lacking prior to heat treatment, which is disadvantageous in terms of restricting steps that utilize the action of heat. Thus, in the case of assembling chips in packages as previously mentioned, an adhesive layer is again required between the chips and base when said chips are fixed on a base (e.g., the die pad of a substrate) (and this fixing step is usually referred to as "die bonding").

In order to solve the problems of the prior art as described above, adhesive tape has been disclosed that separates into an adhesive tape base material (i.e., backing material) and pressure-sensitive adhesive layer or adhesive layer so as to be directly applicable to both dicing and die bonding. For example, Japanese Unexamined Patent Publication (Kokai) No. 7-45557 discloses an adhesive tape comprising, in the following order, a base material, a radiation-curing, pressure-sensitive adhesive layer containing a pressure sensitive adhesive and a radiation-curing oligomer on the base material, and a die-bonding adhesive layer on the radiation curing, pressure sensitive adhesive layer. In the disclosed invention, a wafer to be diced is placed on the die-bonding adhesive layer, is diced, and then, pressure-sensitive adhesiveness of the pressure-sensitive adhesive to the die-bonding adhesive layer is lowered by the ultraviolet irradiation, and the die-bonding adhesive layer is peeled from the pressure-sensitive adhesive at the interface therebetween in a pick-up process. The produced chip having a die-bonding adhesive thereon is die-bonded to a substrate via the adhesive.

In the above-mentioned references, when a pressure-sensitive adhesive is used during various semiconductor manufacturing processes, the pressure-sensitive adhesive characteristic cannot be completely eliminated from the adhesive. Due to the remaining pressure-sensitive adhesiveness, the diced chip may be damaged. In particular, for a chip having a ground thickness of 100 micrometers or less, damage during the pick-up process is a very serious problem.

According to one embodiment of the present invention, there is provided a heat curable adhesive composition comprising a caprolactone-modified epoxy resin, and a tack reducing component that is a melamine/isocyanuric acid adduct or an organic compound that can be dissolved or dispersed with the modified epoxy resin in a solvent and has a glass transition temperature of 110°C or higher and is not decomposed or modified by heating at a temperature of 250°C or higher within a minute wherein the organic compound is selected from polyacetals, polybutylene terephthalates, polycarbonates, polyether imides, polyether sulfones, polyethylene oxides, polyphenylene sulfides, polyether ether ketones, polyarylates, polysulfones and polyamideimides. Such a heat curable adhesive composition can generate an initial adhesive strength when heat laminated at low temperatures for a short time and during such a heat bonding step the adhesive does not exhibit flow-out or overflow, and after heat curing, it does not lose heat resistance or shear strength. Further, such a composition does not include ionic components, and therefore, it does not cause problems related to corrosion in a semiconductor component or semiconductor apparatus.

According to another embodiment of the present invention, there is provided an adhesive article comprising a layer of the instant heat curable adhesive composition, and a backing layer carrying said adhesive layer on at least a portion of the backing layer. In such adhesive articles comprising a tack reducing component, the tackiness of the adhesive may be lowered. As a result, if this adhesive article is used as a tape for dicing and die-bonding in manufacturing a semiconductor apparatus, the following advantages are obtained. After heat bonding of a wafer to the adhesive layer and dicing the wafer into chips, the adhesive layer along with each of the chips is easily released from the backing layer, and the chip can be die-bonded to a substrate for a semiconductor apparatus via the adhesive layer without interruption. With the present invention, the manufacturing process from the step of dicing into chips to the step of die-bonding can be carried out with a single adhesive.

According to still another embodiment of the present invention, there is provided an adhesive article comprising a heat curable adhesive layer comprising a caprolactone-modified epoxy resin, and a stretchable backing layer. The stretchable backing layer has an elongation of not less than 10% during stretching. The layer backing the adhesive article is stretchable. Therefore, if it is used as a component of a dicing tape in the manufacture of a semiconductor apparatus, after dicing a wafer into chips, the adhesive layer along with each of the chips is easily released from the backing layer, and the chip can be die-bonded to a substrate for a semiconductor apparatus via same the adhesive layer as used in the dicing step.

The present invention provides heat curable adhesive compositions that exhibit an initial adhesive capability and after curing, a high heat resistance and shear strength. Advantageously, embodiments of the adhesive composition of the invention do not cause corrosion of a semiconductor device or semiconductor apparatus. In certain embodiments the present invention provides film adhesives that can be used as a single adhesive for the processes from dicing to die-bonding. In certain embodiments the present invention provides film adhesives for dicing and die-bonding processes of a wafer ground to an ultra-thin thickness (e.g., about 100 µm or less) without using a significant amount of a pressure-sensitive adhesive or without using any pressure-sensitive adhesive during the processes.

The present invention further relates to a process for preparing the instant heat curable adhesive composition comprising: providing a caprolactone-modified epoxy resin; and blending therewith the tack reducing component.

The present invention also relates to a semiconductor apparatus comprising a substrate having at least one semiconductor component mounted thereon, wherein said semiconductor component is fixed to a component-mounting surface of said substrate via a layer of the instant heat curable adhesive composition.

The present invention further relates to a process for preparing a semiconductor apparatus comprising a substrate having at least one semiconductor component mounted thereon comprising:
laminating an adhesive article on one side of a semiconductor wafer having a plurality of the semiconductor components fabricated therein, the adhesive article comprising a heat curable adhesive layer containing a caprolactone-modified epoxy resin and a tack reducing component that is a melamine/isocyanuric acid adduct or an organic compound that can be dissolved or dispersed with the modified epoxy resin in a solvent and has a glass transition temperature of 110°C or higher and is not decomposed or modified by heating at a temperature of 250°C or higher within a minute wherein the organic compound is selected from polyacetals, polybutylene terephthalates, polycarbonates, polyether imides, polyether sulfones, polyethylene oxides, polyphenylene sulfides, polyether ether ketones, polyarylates, polysulfones and polyamideimides, and a stretchable backing layer, wherein said backing layer has an elongation of not less than 10%;
discretely separating the semiconductor components while maintaining the semiconductor wafer and adhesive article in a laminated state;
stretching the backing layer of the adhesive article, followed by separating the semiconductor components with the heat curable adhesive layer adhered thereto from the backing layer; and
fixing the semiconductor components to the surface of the substrate by means of the heat curable adhesive layer.

Fig. 1 is a sectional view showing an adhesive article according to a preferred embodiment of the present invention.
Fig. 2 is a sectional view showing a semiconductor apparatus according to a preferred embodiment of the present invention.
Fig. 3(A-E) shows a sectional view showing sequentially a method of manufacturing a semiconductor apparatus according to the present invention (first half of the manufacturing process: dicing of the wafer, then stretching of the backing).
Fig. 4(A-C) shows a sectional view showing sequentially a method of manufacturing a semiconductor apparatus according to the present invention (last half of the manufacturing process: chip pickup, then die bonding/attachment).
Fig. 5 is a sectional view showing a semiconductor apparatus according to another preferred embodiment of the present invention.

The heat curable adhesive composition, the adhesive article, the semiconductor apparatus and the method for preparing the semiconductor apparatus according to the present invention can be carried out, respectively, in various embodiments within the scope of the invention. In the embodiment of an adhesive article comprising a backing layer and a heat curable adhesive composition on the backing layer used for both dicing and die-bonding, the adhesive layer selected can be effectively used as a die-bonding adhesive and can also be released from the backing layer after chip dicing. In the present invention, such features are fulfilled by incorporating a tack reducing component into the heat curable adhesive composition in order to impart a sufficient releasability or by using a stretchable material as the backing layer, or both.

The present invention will be described below with reference to appended drawings showing typical preferred embodiments thereof. As will be readily apparent to those skilled in the art, the present invention is by no means limited to the embodiments described below. In drawings, same or similar component is denoted by same reference numeral or symbol.

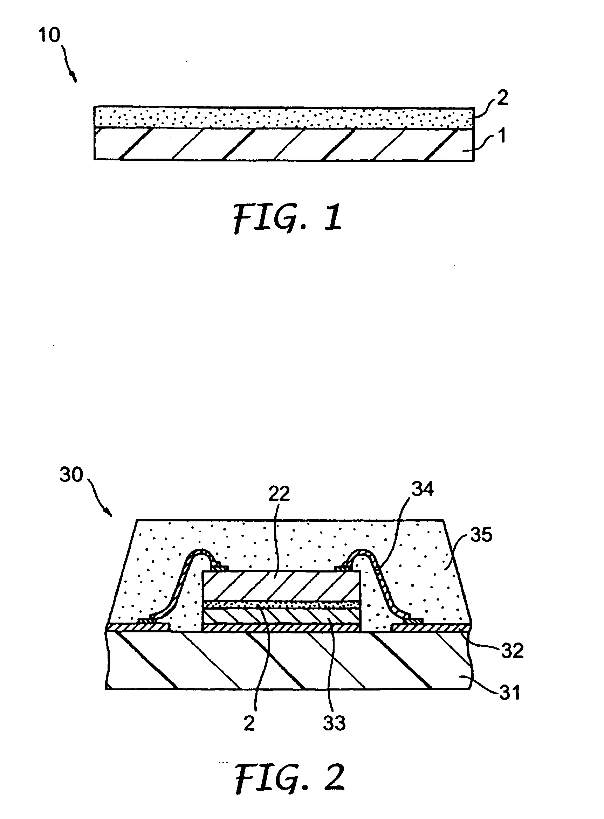

Fig. 1 is a sectional view schematically showing an adhesive article according to an embodiment of the present invention. As shown in the figure, the adhesive article 10 comprises a backing layer 1 as a base material carrying, on one surface thereof, a heat curable adhesive layer 2 consisting of a heat curable adhesive composition of the invention. Thus, in the example shown, a combination of the adhesive layer 2 and the backing layer 1 constitutes the adhesive article 10. However, if the adhesive layer 2 is a self-supporting film in itself, the adhesive layer alone may constitute the adhesive article.

The heat curable adhesive composition that constitutes the heat curable adhesive layer typically has a crystalline phase. In particular, this crystalline phase contains a caprolactone-modified epoxy resin (hereinafter referred to as "modified epoxy resin"). The modified epoxy resin is intended to give suitable flexibility to the heat curable adhesive composition to thereby improve the visco-elastic property of the heat curable adhesive layer. As a result, the heat curable adhesive layer possesses a cohesive property even before heat curing, and begins to exhibit adhesive strength in the initial stage of use. Like ordinary epoxy resins, the modified epoxy resin forms, at an elevated or ordinary temperature, a cured material consisting of a three dimensional network structure that provides desirable cohesive characteristics to the cured adhesive layer.

According to the present invention, in view of improving the initial adhesive strength, the modified epoxy resin has an epoxy equivalent typically in the range of 100 to 9,000, preferably in the range of 200 to 5,000, more preferably in the range of 500 to 3,000. A modified epoxy resin having such an epoxy equivalent is commercially available, for example, under the trade name of Placcel^{™} G series from Daicel Chemical Industries Co.

The heat curable adhesive composition of the present invention comprises a tack reducing component in combination with the above-mentioned modified epoxy resin. The tack reducing component is a melamine/isocyanuric acid adduct (hereinafter also referred to as "melamine/isocyanuric acid complex"), or organic compounds which, with the above-mentioned modified epoxy resin, can be dissolved or dispersed in a solvent and have a glass transition temperature of 110°C or higher and are not decomposed or modified by heating at a temperature of 250°C or higher within a minute. The melamine/isocyanuric acid complex is commercially available, for example, as MC-600 from Nissan Chemical Industries Co., and acts to reduce the tackiness of the heat curable adhesive composition before heat curing and aiding the thixotropic property. It is also effective for reinforcing (e.g., decreasing the coefficient of thermal expansion) the heat curable adhesive composition, and restraining moisture absorption and fluidization of the heat curable adhesive composition. The heat curable adhesive composition of the invention may contain the melamine/isocyanuric acid complex, in order to enhance above-mentioned effect and to prevent embrittlement (maintain ductility) after heat curing, in an amount typically in the range of 1 to 200 parts by weight, preferably in the range of 2 to 150 parts by weight, more preferably in the range of 10 to 100 parts by weight based on 100 parts by weight of the modified epoxy resin.

The engineering thermoplastic resins which have a glass transition temperature of 110°C or higher and are not decomposed or modified by heating at a temperature of 250°C or higher within a minute which can be used as the tack reducing component are selected from polyacetals, polybutylene terephthalates, polycarbonates, polyether imides, polyether sulfones, polyethylene oxides, polyphenylene sulfides, polyether ether ketones, polyarylates, polysulfones, and polyamideimides. Such tack reducing component can be contained in an amount typically in the range of 1 to 200 parts by weight, preferably in the range of 2 to 150 parts by weight, more preferably in the range of 10 to 100 parts by weight based on 100 parts by weight of the modified epoxy resin.

In addition to above-described modified epoxy resin and the tack reducing component, the heat curable adhesive composition of the present invention may contain various additives in amounts that do not impair the object and effect of the desired embodiment of the invention.

For example, the heat curable adhesive composition may contain another material for further reinforcing the adhesive layer. A non-limiting example of suitable material is a rubber-type filler. A rubber-type filler is effective, especially when including methylmethacrylate- butadiene- styrene copolymer or methylacrylate-butylacrylate copolymer, for further increasing the adhesive strength of the heat curable adhesive composition. The rubber-type filler materials consisting of these copolymers are commercially available in the form of particles or powder, for example, as EXL 2691A or EXL 2314 from Rohm & Haas Co. The added material may be contained in the heat curable adhesive composition typically in the range of 1 to 500 parts by weight, preferably 5 to 400 parts by weight, more preferably 10 to 300 parts by weight based on 100 parts by weight of the modified epoxy resin.

The heat curable adhesive composition may further contain a phenoxy resin. A phenoxy resin is a thermoplastic resin of relatively high molecular weight in chain or linear structure, consisting of epichlorohydrin and bisphenol A. Such a phenol resin has good workability, and can be used advantageously to form the heat curable adhesive layer easily into a desired shape. According to the present invention, the phenoxy resin may be contained, relative to 100 parts by weight of the modified epoxy resin, typically in the range of 10 to 300 parts by weight, preferably in the range of 20 to 200 parts by weight, more preferably in the range of 25 to 150 parts by weight in the heat curable adhesive composition. The phenoxy resin can be effectively dissolved in above-mentioned modified epoxy resin so that the bleed of the modified epoxy resin from the heat curable adhesive composition may be effectively prevented. In addition, the phenoxy resin and the above-mentioned modified epoxy resin in the cured state are entangled with each other so that the final properties such as cohesion and heat resistance, etc., of the heat curable adhesive layer can be further increased once cured.

A second epoxy resin (hereinafter referred to simply as "epoxy resin") may be further included, in addition to or independently of above described phenoxy resin, in the heat curable adhesive composition as required, to form a part of above-mentioned cured material. This epoxy resin is not particularly restricted, and examples of useful epoxy resins include bisphenol A epoxy resin, bisphenol F epoxy resin, bisphenol A diglycidyl ether epoxy resin, phenol novolak epoxy resin, cresol novolak epoxy resin, fluorene epoxy resin, glycidyl amine resin, aliphatic epoxy resin, brominated epoxy resin, fluorinated epoxy resin, and the like. Like the modified epoxy resin, these epoxy resins can be dissolved with the phenoxy resin, and little bleed is produced from the heat curable adhesive composition. In particular, when the heat curable adhesive composition contains the second epoxy resin in an amount preferably in the range of 50 to 200 parts by weight, and more preferably in the range of 60 to 140 parts by weight, relative to 100 parts by weight of the modified epoxy resin, heat resistance can be improved advantageously.

In implementing the present invention, the bisphenol A diglycidyl ether epoxy resin (hereinafter referred to as "diglycidyl ether epoxy resin"), in particular, can be used as a preferable epoxy resin. The diglycidyl ether epoxy resin is a liquid, and can improve, for example, the high temperature characteristics of the heat curable adhesive composition. For example, by using the diglycidyl ether epoxy resin, chemical resistance and glass transition temperature can be improved by curing at elevated temperatures. In addition, there is provided a greater range and variety of curing agents from which to select from and relatively mild curing conditions are useful. Such a diglycidyl ether epoxy resin is commercially available, for example, as D.E.R.™ 332 from Dow Chemical (Japan) Co.

A curing agent may be added to the heat curable adhesive composition as required in order to promote the curing reaction of the modified epoxy resin and the second epoxy resin. There is no special restriction to the amount and type of the curing agent as long as it meets the object of the invention and exhibits the desired effect. However, in view of improvement of heat resistance, the curing agent may be contained in an amount typically in the range of 1 to 50 parts by weight in one embodiment. In another embodiment, the curing agent is provided preferably in the range of 2 to 40 parts by weight, and more preferably in the range of 5 to 30 parts by weight. The above amounts are relative to 100 parts by weight of modified epoxy resin and, if used, the second epoxy resin. Useful examples of curing agents include amine curing agents, acid anhydrides, dicyandiamides, cation polymerization catalysts, imidazole compounds, hydrazine compounds, etc. In particular, dicyandiamides may be mentioned as a promising curing agent from the viewpoint of thermal stability at room temperature.

Further, in combination with above-mentioned curing agent or separately from it, a curing accelerator may be contained in the heat curable adhesive composition typically in an amount up to 10 parts by weight, preferably up to 5 parts by weight, and more preferably up to 3 parts by weight, to accelerate the curing reaction. As a result, the heat curable adhesive composition can develop adhesive strength more rapidly as desired. An example of such a curing accelerator is a urethane adduct, such as the adduct of icocyanate and amine which can be thermally decomposed and generate a reactive amine component at relatively low temperatures (e.g., 80-150°C, while melamine/isocyanurate as mentioned above is thermally stable material below 300°C). A suitable urethane adduct is commercially available as Omicure^{™} 52 from PTI Japan Co.

To the heat curable adhesive composition of the invention, various types of pressure sensitive adhesive-type materials, e.g., acrylics, rubber-types, olefinics, or silicones may be added in so far as the heat resistance or shear strength of the adhesive, in particular, of the cured die-bonding adhesive, is not lessened to a level undesirable in the selected embodiment. However, the heat curable adhesive composition of the invention has a sufficient initial adhesive strength without adding such components in most embodiments. Thus, the adhesive composition often need not comprise substantial amounts of such pressure sensitive adhesive components, if they are used at all.

In addition, according to the present invention, if the phenoxy resin, modified epoxy resin and second epoxy resin are contained in the heat curable adhesive layer as previously described, the adhesive strength is able to vary considerably according to heating temperature and/or heating time by the time curing is finally completed. More specifically, although the adhesive strength of the heat curable adhesive layer increases due to initial heating, its adhesive strength decreases when heating continues to a predetermined temperature, to facilitate separation of the backing layer from the curable adhesive layer. However, this heat curable adhesive layer is able to be further heated (or reheated) to obtain a final cured state making it possible to recover and improve its adhesive strength.

In the adhesive article of the present invention, the thickness of the heat curable adhesive layer may be varied over a wide range. The thickness of the heat curable adhesive layer in various embodiments is typically in the range of about 1 to 100 micrometers (µm), preferably in the range of about 2 to 40 µm, and more preferably in the range of about 4 to 30 µm.

As has been described in the foregoing, the illustrated adhesive article 10 has a backing layer 1 disposed on one surface of the heat curable adhesive layer 2. In the practice of the present invention, there is no special restriction to type and thickness of the backing layer, and a backing material generally used in the field of dicing tape and die bonding tape may be used as it is or after a desired improvement or modification such as blending with another material.

In accordance with the finding of the inventors, use of special backing layer, that is, use of backing layer, is recommended for improving the workability of the film. By stretching the backing layer of the adhesive article, the heat curable adhesive layer can be separated from the backing layer with the shape of the layer substantially retained as it is, such that the die and adhesive remain together. More specifically, in view of facilitating the separation of the adhesive article, the backing layer has stretchability of typically 10% or more, preferably 20% or more, and more preferably 30% or more, as a lower bound, and typically of 200% or less as an upper bound in various embodiments. In other words, the stretchability of the backing layer typically is in the range of about 10 to 200%, preferably in the range of about 20 to 180%, and in other embodiments even more preferably in the range of about 30 to 150%.

A stretchable backing layer as described above includes a thermoplastic elastomer. Typical examples of thermoplastic elastomers include, but are not limited to, polystyrene thermoplastic elastomers, thermoplastic olefin elastomers, polyvinyl chloride (PVC) thermoplastic elastomers, polyester thermoplastic elastomers, polyether thermoplastic elastomers, polyurethane thermoplastic elastomers, polyamide thermoplastic elastomers, fluoropolymer thermoplastic elastomers, homopolymer thermoplastic elastomers, ionomer thermoplastic elastomers, and alloy thermoplastic elastomers. These thermoplastic elastomers may be used alone or in combination of two or more of them.

When, the adhesive article of the present invention includes a backing layer, the backing layer contains, in particular, olefin thermoplastic elastomer, homopolymer consisting of polypropylene and/or alloy thermoplastic elastomer. Such backings layers can be separated easily from the heat curable adhesive layer. An olefin thermoplastic elastomer is composed of, for example, a hard segment (hard component) consisting of polyethylene or polypropylene and a soft segment (soft component) including ethylenepropylene-diene terpolymer (EPDM), butyl rubber, ethylene vinylacetate copolymer (EVA), styrene butadiene rubber (SBR), or hydrated SBR (HSBR). The above described homopolymer/alloy thermoplastic elastomer comprises, for example, a hard component consisting of isotactic polypropylene (isotactic PP) and a soft component consisting of atactic polypropylene (atactic PP). Preferably, 55 to 95 mol% of isotactic PP and 5 to 45 mol% of atactic PP, respectively, are contained in a polypropylene homopolymer and/or polypropylene component of a thermoplastic elastomer alloy. If the atactic component is less than 5 mol%, the effect of soft component does not manifest itself and sufficient extension cannot be expected. If the atactic component is more than 45 mol%, a desirable backing substrate material cannot be formed. Such homopolymers and/or thermoplastic elastomer alloys can be prepared using Idemitsu TPO series, commercially available from Idemitsu Petrochemical Co., alone or in a combination of two or more of them.

In the adhesive article of the present invention, the thickness of the backing layer may vary over wide range depending upon the application of the adhesive article. Thickness of the backing layer is typically in the range of about 10 to 2,000 micrometers, preferably in the range of about 30 to 1,000 micrometers, and more preferably in the range of about 50 to 500 micrometers.

Typically, the adhesive article of the present invention is formed mainly or solely from the heat curable adhesive layer in the shape of a self-supporting film, or from two layers involving a backing layer and a heat curable adhesive layer. However, it may include additional layers generally used in the field of adhesive articles, or may be subjected to additional treatment such as a surface treatment. Typical examples of the additional layers include a release coated polymeric film or release paper.

The heat curable adhesive composition of the present invention can be easily prepared using well known conventional methods. Solvents such as methyl ethyl ketone (MEK) or tetrahydrofuran (THF) may be added to the heat curable adhesive composition, as required. The object is to form the heat curable adhesive composition in the shape of an adhesive film, sheet, or tape. By adding above-mentioned solvent, the heat curable adhesive composition becomes more fluidized so that it can be easily formed in the shape of a film, sheet, or tape.

The adhesive article of the present invention can be fabricated using any of ordinary methods such as die coating, knife coating, screen printing or the like. An example of a generally applicable method will be briefly described below.

A solution containing the above-mentioned adhesive components is coated on a polyester film treated with a release coating. Then, the coated film is passed through an oven to evaporate the solvent, and a heat curable adhesive layer is obtained.

Next, the surface of the adhesive is superimposed onto the above-described backing layer, and heat transfer lamination is performed. For heat transfer lamination, any heating means such as a heat roller, heat laminator, hot press, etc., can be used. The heat transfer lamination can be performed at relatively low temperatures (for example, about 90 to 120°C) in a short time (for example, about 0.1 to 10 seconds). As a result of the heat transfer lamination, the adhesive layer can be bonded to the backing layer, and the adhesive layer can provide adhesive performance at very high level required for die bonding. Apart from the heat transfer lamination of the adhesive layer and backing layer, an adhesive article can also be prepared by directly coating a solution containing the adhesive components onto a backing layer or the like, and evaporating and removing the solvent therein.

The adhesive article of the present invention has excellent characteristics, and hence can be advantageously used in various fields. Suitable application of the adhesive article may be found in the field of electronic apparatus which contain electronic devices such as semiconductor components, for example, semiconductor chips such as IC, LSI, etc., capacitors or other parts mounted on the surface of a substrate, or in the interior as required. One or more semiconductor components or other electronic components, or any combination of two or more such components, may be mounted on and/or inside the substrate of the electronic apparatus. Two or more electronic components may be arranged in stack structure to construct a more compact and high-density electronic apparatus.

The adhesive article of the present invention can be used particularly advantageously in the manufacture of a semiconductor apparatus comprising a semiconductor component such as IC, LSI, etc., since, when the adherend is a semiconductor component such as IC, LSI or the like, the adhesive article can be effectively used in the connection, that is, die bonding of such adherend.

Fig. 2 is a sectional view showing an example of a semiconductor apparatus according to the present invention. As shown, a semiconductor apparatus 30 has a circuit board 31 which was manufactured by processing of a laminate covered with copper to form copper circuitry 32 in a pattern on its upper surface. A die pad 33 formed of solder resist is provided on the component mounting region of the circuit board 31, and a semiconductor component (in this example, an LSI) 22 is joined via the adhesive layer 2 to the top of the die pad. The semiconductor component 22 is connected through a gold bonding wire 34 to the copper circuitry 32, as shown in the Figure. The top surface of the semiconductor apparatus 30 is sealed by epoxy resin 35 in order to protect the mounted semiconductor component 22 and the bonding wire 34 from external moisture and shock. A solder ball (not shown) is mounted as an external terminal to the underside of the circuit board 31. Although only one semiconductor component 22 is mounted to the semiconductor apparatus 30 shown in the figure, another semiconductor component may be mounted via an adhesive layer of the invention to the semiconductor component 22, so as to form a so-called stacked FBGA. Higher density packaging is made possible through stacking of semiconductor components in this manner.

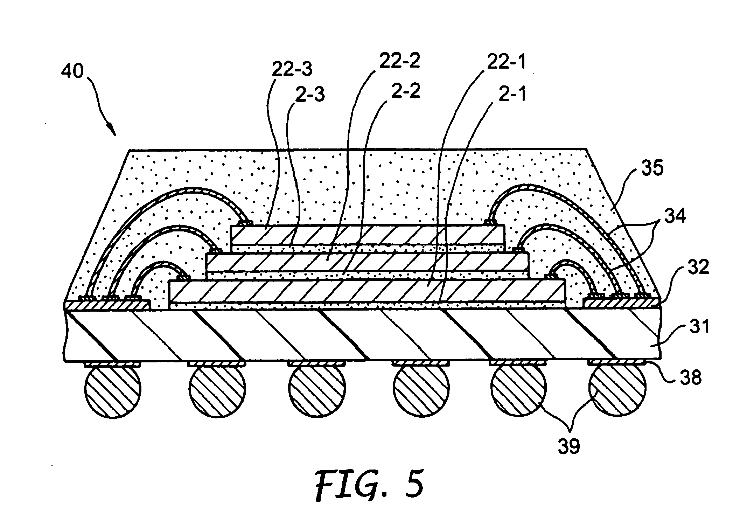

Fig. 5 illustrates one example of the stacked FBGA. In the semiconductor apparatus 40, as is illustrated, three different semiconductor components 22-1, 22-2 and 22-3 are mounted on a printed circuit board 31. The adhesive layer employing the present invention is used to provide each of the adhesive layers 2-1, 2-2 and 2-3. Each semiconductor component is connected through a gold bonding wire 34 to copper circuitry 32. Solder balls 39 acting as an external terminal are applied to copper circuitry 39 formed on a lower surface of the circuit board 31. Top surface of the semiconductor apparatus 40 is sealed by epoxy resin 35.

In accordance with the present invention, there is provided a method for manufacturing a semiconductor apparatus or other electronic apparatus using the adhesive article of the invention. For example, a method for manufacturing a semiconductor apparatus according to the present invention can be advantageously implemented in the following steps.

### (1) Arranging the adhesive article

The adhesive article of the present invention is arranged on the dicing device for dicing a semiconductor wafer so as to expose the adhesive layer.

### (2) Mounting a semiconductor wafer

A wafer having a plurality of semiconductor components formed thereon is provided and mounted on the adhesive article with one surface (non-component mounting surface) facing downward, and adhered to the adhesive article. In accordance with the present invention, the heat curable adhesive composition does not contain ionic components, and therefore, there is no problem with corrosion arising from ionic components.

### (3) Heat Bonding of the semiconductor to the adhesive article using heat and pressure.

After stacking the semiconductor wafer on the adhesive article, they are heat bonded and optionally, the adhesive article is partially cured. The heating temperature and duration as well as applied pressure for the heat bonding step may vary depending upon the composition of the adhesive layer. Typically, heating is performed at a temperature in the range of about 90 to 120°C, for time period in the range of about 0.1 to 60 seconds, and under a pressure in the range of about I to 20 kg/cm² (0.1 to 2 MPa). A heating means such as a heat roller, heat laminator, hot press, or the like can be used. As a result of the heat bonding step, the semiconductor wafer is joined to the adhesive article to form an integral unit.

According to the present invention, the fluidity and tackiness of the heat curable adhesive composition are suppressed when tack reducing component such as the above-mentioned melamine/isocyanuric acid adduct is added. As a result, the heat bonding can be performed at a lower temperature and lower pressure in a shorter time so that the load imposed upon the semiconductor wafer is greatly reduced, and hence damage such as cracks, etc., during heat bonding can be reduced or eliminated, even when a semiconductor wafer with its thickness reduced in grinding or polishing steps, or the like, is used.

In this connection, fluidity of the heat curable adhesive composition may also be suppressed by using inorganic substance such as silica. However, the tack reducing component such as the melamine/isocyanuric acid adduct differs from silica in that it is an organic substance, and hence it hardly damages a semiconductor wafer even if it is brought into contact with the semiconductor wafer. Thus, by using the tack reducing component such as the melamine/isocyanuric acid adduct, productivity in the manufacture of the semiconductor apparatus is expected to be improved regardless of the thickness of the semiconductor wafer.

In the state of this integrated laminate, or after the completion of the dicing process at the subsequent stage, processing such as plating, polishing, etching or the like may be performed on the semiconductor wafer.

### (4) Dicing of the semiconductor wafer

While the semiconductor wafer remains in the state with the adhesive article laminated to it, the wafer is cut into individual semiconductor components. Since the adhesive article has acquired sufficient adhesive strength as a result of partial curing by the above-mentioned heat bonding step, semiconductor wafers cut into a plurality of components or chips (also referred to as "die") can effectively be prevented from becoming scattered about. As for cutting methods, ordinary means for cutting such as a dicing saw, diamond cutter, etc. may be used. Further, a ring-like support (a ring frame) is employed to enclose and fix the mounted wafer and the wafer is diced in the fixed state so that damage to the chips can be avoided.

### (5) Pick-up of semiconductor components

After dicing of the semiconductor wafer is completed, each of the semiconductor components obtained by cutting the wafer is separated from the backing layer with the heat curable adhesive layer remaining attached to the components. In this process, a conventional pick-up rod or a compact and efficient vacuum suction apparatus may be used. Further, since the backing layer is stretchable, a conventional means such as a pick-up rod is not required to be used as a releasing means, and a vacuum suction apparatus can be used to release the semiconductor component from the backing layer.

### (6) Die mounting

The semiconductor component with the heat curable adhesive layer attached thereto is fixed to the surface of the substrate for manufacturing a semiconductor apparatus, for example to the die pad, via the heat curable adhesive layer, and bonded under heat and pressure. This heat bonding can be performed with little restriction as described above. The adhesive layer can thus firmly bond the semiconductor chip to the die pad after post-curing.

When the semiconductor chip is produced from a thinned semiconductor wafer, a plurality of these semiconductor chips can be stacked one upon another by repetition of above described process. In such a case, by adopting the multi-chip packaging (MCP) scheme, a plurality of integrated circuit chips or individual semiconductor elements may be housed in a package such as used in an integrated circuit component in order to realize a higher density and more compact semiconductor apparatus.

### (7) Wire bonding etc.

After die mounting is completed, subsequent processing such as wire bonding (or, flip chip bonding), sealing with resin, ball mounting, etc. are performed using conventional methods.

Although preferred embodiments of the present invention have been described in the foregoing, the present invention is by no means restricted to above described embodiments. For example, the heat curable adhesive composition of the present invention can also be applied effectively to processes other than die bonding. More specifically, the heat curable adhesive composition can be used to manufacture printed circuit boards or the like.

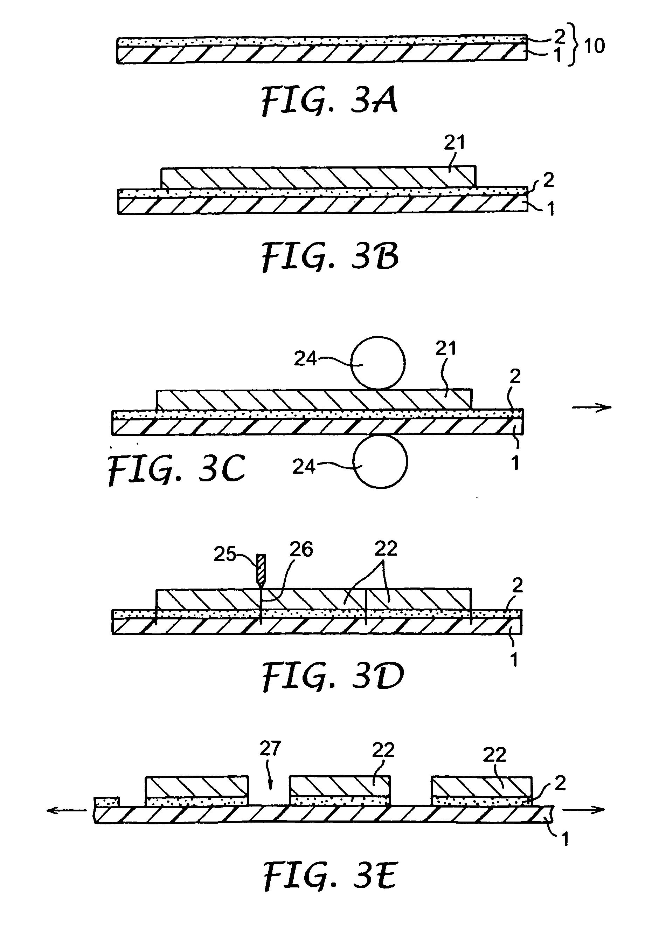

Figs. 3(A-E) and 4(A-C) are sectional views showing an example of the method for manufacturing a semiconductor apparatus following above described procedure in sequential steps.

First, as shown in Fig. 3(A), an adhesive article 10 consisting of a backing layer 1 and a heat curable adhesive layer 2 is fixed to a dicing apparatus (not shown) with the adhesive layer 2 facing upward. A ring support (a ring frame), for example, is used as fixing means.

Next, as shown in Fig. 3(B), a semiconductor wafer 21 is mounted on the heat curable adhesive layer 2 of the adhesive article 10.

Then, as shown in Fig. 3(C), the semiconductor wafer 21 and the adhesive article 10 are guided between a pair of rollers 24 in the direction of the arrow for heat lamination. Here, the semiconductor wafer 21 is brought into close contact with the heat curable adhesive layer under a predetermined pressure (e.g., from about 0.1 to about 5 MPa) to prevent damaging of the wafer. Heating temperature is typically in the range of about 70 to 180°C, preferably about 80 to 150°C, and more preferably about 90 to 120°C. Duration of heating is typically in the range of about 0.01 to 30 seconds, preferably about 0.1 to 10 seconds, and more preferably about 0.2 to 5 seconds. Immediately after the heat laminating step, the heat curable adhesive layer 2 can hold the semiconductor wafer 21 with high adhesive strength. Further, although not shown in the figure, if an adhesive article consists essentially of a heat curable adhesive composition on a backing, then a semiconductor wafer 21, a heat curable adhesive layer 2 and a backing layer 1 having a ring support thereon are heat laminated, to form a wafer enclosed by a ring support/adhesive layer/backing layer. Due to this structure, it is not necessary to laminate the backing layer 1 of wafer/adhesive layer/backing layer construction onto second wafer mounting tape (i.e., a dicing tape) via a pressure-sensitive adhesive etc., and the adhesive article 10 itself can act as a dicing tape.

Then, as shown in Fig. 3(D), dicing is performed on the semiconductor wafer 21. together with the heat curable adhesive layer 2 at the dicing line 26. A dicing saw 25 is used as the dicing means. As shown, a plurality of semiconductor components 22 (also referred to as "semiconductor chips") is obtained. Since the heat curable adhesive layer 2 has high adhesive strength, it acts very effectively to prevent scattering of the semiconductor chips 22. As required, processing steps such as plating, polishing or etching may be performed in advance on the semiconductor wafer 21 before dicing.

Next, in the embodiment having a stretchable backing layer, as shown in Fig. 3(E), backing layer 1 is stretched in the directions indicated by the arrows with the aggregate of semiconductor chips 22 still mounted. Adjacent semiconductor chips 22 are pulled apart at the locations of the dicing lines, and separated by spaces 27 as shown in the drawing. At this time, heating may be performed to a somewhat high temperature prior to the stretching step as necessary. Due to this heating, the adhesive strength of the heat curable adhesive layer is lowered, and as a result, the heat curable adhesive layer can be more easily separated from the backing layer with less stretching. However, the adhesive strength of the thermosetting adhesive layer is not lowered to the extent that it separates from the semiconductor chips. As a result, the heat curable adhesive layer transfers to the semiconductor chips. Here, the heating temperature is normally about 80-180°C, preferably about 90-150°C, and more preferably about 100-130°C. In addition, the heating time is normally about 5-360 minutes, preferably about 10-120 minutes, and more preferably about 20-60 minutes.

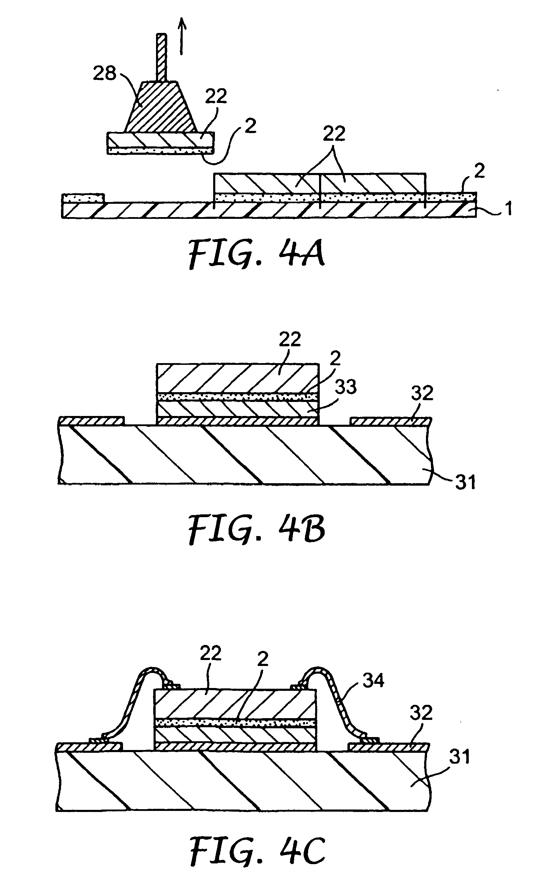

Next, as shown in Fig. 4(A), a vacuum suction apparatus 28 is used to pick up the semiconductor chip 22 together with the heat curable adhesive layer 2. The vacuum suction apparatus 28 can reduce impact or load applied to the semiconductor chip 22. The heat curable adhesive layer 2 is peeled off from the backing layer 1 and is transferred to the semiconductor chip 22. A pick-up rod may be used in place of the vacuum suction apparatus.

Then, as shown in Fig. 4(B), the semiconductor chip 22 is mounted on the die pad 33 on the circuit board 31 via the attached heat curable adhesive layer 2. By subsequent heat bonding of the semiconductor chip to the die pad, the adhesive layer is further cured and the semiconductor chip and the die pad can be adhered to each other firmly, since upon further curing the adhesive layer restores/improves adhesive strength and heat resistance.

After mounting of the semiconductor chip 22 is completed, as shown in Fig. 4(C), wire bonding is performed between the semiconductor chip 22 and the copper circuitry 32 of the circuit board 31 via a gold bonding wire 34. Depending upon the construction of the semiconductor apparatus, flip chip bonding may be used in place of wire bonding. For example, in case of flip chip bonding, bumps (stud bumps) can be formed on die pads in the active layer of the Si-wafer involving the wire bonding process. The adhesive film of the invention can be applied on the active layer using the conditions as described above (see 3 Heat Bonding). Then the face down chip (flip chip) can be bonded on the substrate, such as with heat and pressure. The bump penetrates the adhesive film and contacts circuits on the substrate.

Subsequently, processing steps such as sealing with resin, ball mounting, etc. are performed (not shown) to finally obtain a semiconductor apparatus. The resin-sealed semiconductor apparatus was described above with reference to Fig. 2.

As is well known, with the progress of miniaturization of chips and high density packaging, a wide variety of semiconductor apparatuses have been proposed. The above-described method for manufacturing a semiconductor apparatus according to the present invention can be advantageously used for manufacturing these semiconductor apparatuses.

The present invention has been described above especially with respect to preferred embodiments. These preferred embodiments are summarized as follows.
(Embodiment 1) A heat curable adhesive composition comprising: a caprolactone-modified epoxy resin; and a tack reducing component that is a melamine/isocyanuric acid adduct or an organic compound that can be dissolved or dispersed with the modified epoxy resin in a solvent and has a glass transition temperature of 110°C or higher and is not decomposed or modified by heating at a temperature of 250°C or higher within a minute wherein the organic compound is selected from polyacetals, polybutylene terephthalates, polycarbonates, polyether imides, polyether sulfones, polyethylene oxides, polyphenylene sulfides, polyether ether ketones, polyarylates, polysulfones and polyamideimides.
(Embodiment 2) A heat curable adhesive composition according to Embodiment 1 ,wherein said caprolactone-modified epoxy resin has epoxy equivalent of 100 to 9000.
(Embodiment 3) A heat curable adhesive composition according to Embodiment 1, wherein said melamine/isocyanuric acid adduct is contained in an amount of 1 to 200 parts by weight.
(Embodiment 4) A heat curable adhesive composition according to any one of Embodiments 1 to 3 ,further comprising a rubber-like filler.
(Embodiment 5) A heat curable adhesive composition according to any one of Embodiments 1 to 4 further comprising a phenoxy resin.
(Embodiment 6). A heat curable adhesive composition according to any one of Embodiments 1 to 5, further comprising a second epoxy resin selected from the group consisting of bisphenol A epoxy resin, bisphenol F epoxy resin, bisphenol A diglycidyl ether epoxy resin, phenol novolak epoxy resin, cresol novolak epoxy resin, fluorene epoxy resin, glycidyl amine resin, aliphatic epoxy resin, brominated epoxy resin, and fluorinated epoxy resin.
(Embodiment 7) A heat curable adhesive composition according to any one of Embodiments 1 to 6, wherein initial adhesive strength is developed by heating.
(Embodiment 8) A heat curable adhesive composition according to any one of Embodiments 1 to 7, characterized in that the adhesive composition is used in dicing process and/or die bonding process in the manufacture of a semiconductor apparatus.
(Embodiment 9) An adhesive article comprising: a heat curable adhesive layer of a heat curable adhesive composition comprising a caprolactone-modified epoxy resin and a tack reducing component that is a melamine/isocyanuric acid adduct or an organic compound that can be dissolved or dispersed with the modified epoxy resin in a solvent and has a glass transition temperature of 110°C or higher and is not decomposed or modified by heating at a temperature of 250°C or higher within a minute wherein the organic compound is selected from polyacetals, polybutylene terephthalates, polycarbonates, polyether imides, polyether sulfones, polyethylene oxides, polyphenylene sulfides, polyether ether ketones, polyarylates, polysulfones and polyamideimides; and a backing layer carrying said adhesive layer on at least a portion of the backing layer.
(Embodiment 10) An adhesive article according to Embodiment 9 wherein, in said heat curable adhesive composition, said caprolactone-modified epoxy resin has epoxy equivalent of 100 to 9000.
(Embodiment 11) An adhesive article according to any one of Embodiments 9 and 10, wherein, in said heat curable adhesive composition, said tack reducing component is contained in an amount of 1 to 200 parts by weight.
(Embodiment 12) An adhesive article according to any one of Embodiments 9 to 11, wherein said heat curable adhesive composition further contains a rubber-like filler.
(Embodiment 13) An adhesive article according to any one of Embodiments 9 to 12, wherein said heat curable adhesive composition further contains a phenoxy resin.
(Embodiment 14) An adhesive article according to any one of Embodiments 9 to 13, wherein said heat curable adhesive composition further contains a second epoxy resin selected from the group consisting of bisphenol A epoxy resin, bisphenol F epoxy resin, bisphenol A diglycidyl ether epoxy resin, phenol novolak epoxy resin, cresol novolak epoxy resin, fluorene epoxy resin, glycidyl amine resin, aliphatic epoxy resin, brominated epoxy resin, and fluorinated epoxy resin.
(Embodiment 15) An adhesive article according to any one of Embodiments 9 to 14, wherein said backing layer is a stretchable plastic film which exhibits elongation percentage of 10% or more when stretched.
(Embodiment 16) An adhesive article according to Embodiments 9 to 15, wherein said backing layer comprises at least one thermoplastic elastomer selected from the group consisting of polystyrene thermoplastic elastomers, olefin thermoplastic elastomers, polyvinyl chloride (PVC) thermoplastic elastomers, polyester thermoplastic elastomers, polyether thermoplastic elastomers, polyurethane thermoplastic elastomers, polyamide thermoplastic elastomers, fluoropolymer thermoplastic elastomers, homopolymer thermoplastic elastomers, ionomer thermoplastic elastomers, and alloy thermoplastic elastomers.
(Embodiment 17) An adhesive article according to any one of Embodiments 9 to 16, wherein said backing layer has a thickness of 50 to 500 µm.
(Embodiment 18) An adhesive article according to any one of Embodiments 9 to 17, wherein said heat curable adhesive layer has a thickness of 4 to 30 µm.
(Embodiment 19) A semiconductor apparatus comprising a substrate having at least one semiconductor component mounted thereon, characterized in that said semiconductor component is fixed to the component mounting surface of said substrate via a heat curable adhesive layer of a heat curable adhesive composition comprising a caprolactone-modified epoxy resin and a tack reducing component that is a melamine/isocyanuric acid adduct or an organic compound that can be dissolved or dispersed with the modified epoxy resin in a solvent and has a glass transition temperature of 110°C or higher and is not decomposed or modified by heating at a temperature of 250°C or higher within a minute wherein the organic compound is selected from polyacetals, polybutylene terephthalates, polycarbonates, polyether imides, polyether sulfones, polyethylene oxides, polyphenylene sulfides, polyether ether ketones, polyarylates, polysulfones and polyamideimides.
(Embodiment 20) A semiconductor apparatus according to Embodiment 19, wherein said semiconductor component is fixed to said substrate by heat bonding via said heat curable adhesive layer which has its initial adhesive strength increased by heating.
(Embodiment 21) A semiconductor apparatus according to Embodiment 19 or 24, wherein said heat curable adhesive layer is derived from the heat curable adhesive composition according to any one of Embodiments 1 to 8.
(Embodiment 22) A semiconductor apparatus according to any one of Embodiments 19 to 21, wherein said semiconductor component is fixed on the die pad provided in advance on the surface of said substrate via said heat curable adhesive layer.
(Embodiment 23) A semiconductor apparatus according to any one of Embodiments 19 to 22 wherein said heat curable adhesive layer has been previously applied to the semiconductor wafer in which a plurality of said semiconductor components have been formed.
(Embodiment 24) A semiconductor apparatus according to any one of Embodiments 19 to 23, which comprises a second semiconductor component mounted to the at least one semiconductor component.
(Embodiment 25) A method for manufacturing a semiconductor apparatus including a substrate having at least one semiconductor component mounted thereon, comprising:
   laminating, on one surface of a semiconductor wafer which has a plurality of said semiconductor component formed thereon, an adhesive article comprising a heat curable adhesive layer of a heat curable adhesive composition which comprises a caprolactone-modified epoxy resin and a tack reducing component that is a melamine/isocyanuric acid adduct or an organic compound that can be dissolved or dispersed with the modified epoxy resin in a solvent and has a glass transition temperature of 110°C or higher and is not decomposed or modified by heating at a temperature of 250°C or higher within a minute wherein the organic compound is selected from polyacetals, polybutylene terephthalates, polycarbonates, polyether imides, polyether sulfones, polyethylene oxides, polyphenylene sulfides, polyether ether ketones, polyarylates, polysulfones and polyamideimides, and a backing layer carrying said adhesive layer;
   developing the initial adhesive strength of said heat curable adhesive composition by heat bonding of said semiconductor wafer and the adhesive article;
   dividing said semiconductor wafer into individual semiconductor component while keeping said film adhesive laminated upon the wafer;
   separating said semiconductor component with said heat curable adhesive layer attached thereon from said backing layer; and
   fixing said semiconductor component via said heat curable adhesive layer to the surface of said substrate.
(Embodiment 26) A method for manufacturing a semiconductor apparatus according to Embodiment 25, wherein said semiconductor component is fixed by heat bonding via said heat curable adhesive layer to the surface of said substrate.
(Embodiment 27) A method for manufacturing a semiconductor apparatus according to Embodiment 25 or 26, wherein said semiconductor wafer is divided into individual semiconductor component while supporting the heat bonded laminate of the semiconductor wafer and adhesive article by a ring support.
(Embodiment 28) A method for manufacturing a semiconductor apparatus according to any one of Embodiments 25 to 27, wherein said semiconductor component is separated from said backing layer by means of vacuum suction.
(Embodiment 29) A method for manufacturing a semiconductor apparatus according to any one of Embodiments 25 to 28, wherein said adhesive article is an adhesive layer according to any one of Embodiments 9 to 18.
(Embodiment 30) A method for manufacturing a semiconductor apparatus according to any one of Embodiments 25 to 29, wherein said substrate further comprises a die pad on the surface for mounting semiconductor components.
(Embodiment 31) An adhesive article characterized by comprising a heat curable adhesive layer comprising caprolactone-modified epoxy resin, and a stretchable backing layer having an elongation of not less than 10% during stretching.
(Embodiment 32) An adhesive article according to Embodiment 31 wherein, the modified epoxy resin has an epoxy equivalent of 100-9000.
(Embodiment 33) An adhesive article according to Embodiment 31 or 32 wherein, the heat curable adhesive layer additionally contains a phenoxy resin.
(Embodiment 34) An adhesive article according to any one of Embodiments 31 to 33 wherein, the heat curable adhesive layer additionally contains a filler.
(Embodiment 35) An adhesive article according to any one of Embodiments 31 to 34 wherein, the heat curable adhesive layer has a thickness of 4-30 µm.
(Embodiment 36) An adhesive article according to any one of Embodiments 31 to 35, wherein the elongation of the backing layer is not more than 200%.
(Embodiment 37) An adhesive article according to any one of Embodiments 31 to 36, wherein the elongation of the backing layer is within the range of 20-180%.
(Embodiment 38) An adhesive article according to any one of Embodiments 31 to 37, wherein the elongation of the backing layer is within the range of 30-150%.
(Embodiment 39) An adhesive article according to any one of embodiments 37 to 38, wherein said backing layer comprises a thermoplastic elastomer.
(Embodiment 40) An adhesive article according to Embodiment 39 wherein the thermoplastic elastomer is at least one type of thermoplastic elastomer selected from the group consisting of polystyrene-based thermoplastic elastomers, olefin-based thermoplastic elastomers, polyvinylchloride-based thermoplastic elastomers, polyester-based thermoplastic elastomers, polyether-based thermoplastic elastomers, polyurethane-based thermoplastic elastomers, polyamide-based thermoplastic elastomers, fluoropolymer-based thermoplastic elastomers, homopolymer-based thermoplastic elastomers, ionomer-based thermoplastic elastomers and alloy-based thermoplastic elastomers.
(Embodiment 41) An adhesive article according to any one of Embodiments 31 to 40 wherein the backing layer has a thickness of 50-500 µm.
(Embodiment 42) An adhesive article according to any one of Embodiments 31 to 40 wherein the backing layer has a thickness of 54-530 µm.
(Embodiment 43) A method for manufacturing a semiconductor apparatus including a substrate having at least one semiconductor component mounted thereon, comprising the steps of:
   laminating, on one surface of a semiconductor wafer which has a plurality of said semiconductor components formed thereon, an adhesive article comprising a heat curable adhesive layer comprising a caprolactone-modified epoxy resin and a tack reducing component that is a melamine/isocyanuric acid adduct or an organic compound that can be dissolved or dispersed with the modified epoxy resin in a solvent and has a glass transition temperature of 110°C or higher and is not decomposed or modified by heating at a temperature of 250°C or higher within a minute wherein the organic compound is selected from polyacetals, polybutylene terephthalates, polycarbonates, polyether imides, polyether sulfones, polyethylene oxides, polyphenylene sulfides, polyether ether ketones, polyarylates, polysulfones and polyamideimides, and a stretchable backing layer carrying said adhesive layer having elongation of no less than 10 % upon being stretched;
   dividing said semiconductor wafer into individual semiconductor components while keeping said adhesive article laminated upon the wafer;
   separating said semiconductor component with said heat curable adhesive layer attached thereon from said backing layer after stretching the backing layer of said adhesive article; and
   fixing said semiconductor component via said heat curable adhesive layer to the surface of said substrate.
(Embodiment 44) A method for manufacturing a semiconductor apparatus according to Embodiment 43, wherein after wafer and said adhesive article are stacked, they are integrated by heat lamination.
(Embodiment 45) A method for manufacturing a semiconductor apparatus according to Embodiment 43 or 44, wherein said semiconductor wafer is divided into individual semiconductor components while supporting the heat bonded laminate of the semiconductor wafer and adhesive article by a ring support.
(Embodiment 46) A method for manufacturing a semiconductor apparatus according to any one of Embodiments 43 to 45, wherein said semiconductor component is fixed onto the surface of said substrate by heat bonding via said heat curable adhesive layer.
(Embodiment 47) A method for manufacturing a semiconductor apparatus according to any one of Embodiments 43 to 46, wherein said semiconductor component is separated from said backing layer by means of vacuum suction.
(Embodiment 48) A method for manufacturing a semiconductor apparatus according to any one of Embodiments 43 to 47, wherein the adhesive article is the adhesive article according to any one of Embodiments 31 to 42.
(Embodiment 49) A method for manufacturing a semiconductor apparatus according to any one of Embodiments 43 to 48, wherein the substrate additionally has a die pad on the surface on which semiconductor components are mounted.

### Examples

Now, the present invention will be described below with reference to examples thereof.

### Examples 1 to 6

### Preparation of heat curable adhesive compositions:

Heat curable adhesive compositions (Examples 1 to 6) were prepared by blending various components shown in Table 1 below in the ratio as set forth in the Table. Adhesive components shown in Table 1 were as follows:
phenoxy resin: YP50S, manufactured by Toto Kasei Co., number averaged molecular weight of 11,800;
liquid epoxy resin: DER™ 332, manufactured by Dow Chemical Japan Co., epoxy equivalent weight of 174; caprolactone-modified epoxy resin: Placcel^{™} G402, manufactured by DaicelChemical Industries Co., epoxy equivalent weight of 1350; methacrylate-butadiene-styrene copolymer: EXL-2691 A, described as a methylmethacrylate-butadiene styrene copolymer, from Rohm & Haas Co.; EXL2314, KUREHA PARALOID^{™} EXL, manufactured by Kureha Chemicals Industries Co.; dicyandiamide (DICY): CG-NA, manufactured by PTI Japan Co.; urethane adduct: Omicure^{™} 52, 4,4ⁱ-methylene-bis-phenylene di-urea, from PTI Japan Co.; melamine/isocyanuric acid adduct: MC-600, molecular weight 255, formula C₃H₆N₆+C₃H₃N₃O₃ , melt point > 350°C, manufactured by Nissan Chemical Industries Co.

**Table 1**

| Component | Example 1 | Example 2 | Example 3 | Example 4 | Example 5 | Example 6 |
|---|---|---|---|---|---|---|
| phenoxy resin | 30 | 30 | 30 | 30 | 30 | 30 |
| liquid epoxy resin | 34 | 34 | 34 | 34 | 34 | 34 |
| caprolactone-modified epoxy resin | 30 | 30 | 30 | 30 | 30 | 30 |
| methacrylate-butadiene-styrene copolymer | 6 | 6 | 6 | 6 | 0 | 0 |
| acryl polymer | 0 | 0 | 0 | 0 | 50 | 80 |
| dicyandiamide (DICY) | 2.9 | 2.9 | 2.9 | 2.9 | 2.9 | 2.9 |
| urethane adduct (Omicure 52) | 1.0 | 1.0 | 1.0 | 1.0 | 0 | 0 |
| methanol (MeOH) | 40 | 40 | 40 | 40 | 40 | 40 |
| methyl ethyl ketone (MEK) | 90 | 90 | 90 | 90 | 0 | 0 |
| tetrahydrofuran (THF) | 0 | 0 | 0 | 0 | 240 | 270 |
| melamine/isocyanuric acid adduct | 70 | 15 | 30 | 50 | 50 | 20 |

A homogeneous adhesive solution was obtained by blending various components and mixing at room temperature. Then, the adhesive solution was coated onto a base material consisting of silicone-treated polyethylene terephthalate (PET) film in different amounts, and was dried in an oven at 100°C for 30 minutes. In Examples 1 to 6, PET films having a heat curable adhesive layer in thickness of 30 micrometers (µm), respectively, were obtained (hereinafter referred to as "adhesive transfer tape").

### Evaluation of the heat curable adhesive composition:

As shown below, test samples, were prepared using above-described adhesive transfer tapes, and the heat curable adhesive compositions were evaluated with respect to adhesive strength, tensile shear strength, fluidity, and heat resistance.

### (1) Measurement of adhesive strength

Adhesive transfer tapes were prepared as described above and heat-laminated to a polyimide film (manufactured by DUPONT TORAY Co., trade name "Kapton^{™} V") of 25 µm in thickness. For heat lamination, a laminate of the adhesive transfer tape and the polyimide film was passed between a pair of heated rollers at 100°C. A laminate construction.of 15 mm in width was obtained.

Then, the PET film was peeled from the laminate construction to expose the heat curable adhesive layer, which was adhered to copper foil (size: 10 mm × 50 mm × 35 µm thickness, manufactured by Nippon Foil Mfg Co.). Thus, the sample for peel measuring was Cu/ Adhesive/ Polyimide. This laminate was subjected to heat bonding via the heat curable adhesive layer at a temperature of 120°C under load of 2 Megapascals (MPa) for 60 seconds.

### Initial adhesive strength

Immediately after completion of the heat bonding, copper foil was peeled off from each of the test samples at a peel angle of 180 degrees, and peel strength was measured. Measurements were performed under the following conditions: test temperature was at room temperature (specifically, 25°C) and a peel rate of 50 millimeters/minute was used. The initial adhesive strengths are shown in Table 2 below.

### Adhesive strength after heat curing

Next, the test samples were placed in an oven and heated at 150°C for 1 hour. After heat curing of the heat curable adhesive layer in this manner, the peel strength was measured as described above. The results are shown in Table 2 below.

### (2) Measurement of tensile shear strength

Adhesive transfer tapes prepared as described above were cut into strips of 25 mm in length and 12.5 mm in width. A strip of this adhesive transfer tape was placed onto a cold rolled steel plate (size: 100 mm × 25 mm × 1.5 mm, JIS G3141, SPCC-SB) such that the exposed adhesive surface was in contact with the plate. The PET film was removed and a second cold rolled steel plate was placed on the newly exposed adhesive surface such that there was a 25 millimeter overlap area in the lengthwise direction between the two plates. This layup was heat bonded to provide a test laminate. Conditions for the heat bonding were: temperature 120°C, pressure 2 MPa, and press duration 30 seconds. The test laminate was placed in an oven at 150°C and post-curing of the adhesive layer was performed for 1 hour to provide a tensile test sample.

The resulting test sample was evaluated for tensile strength at a separation rate of 50 millimeters/minute, and the maximum stress produced was recorded. Tensile shear strength was obtained by dividing the maximum stress by overlap adhesion area. The results are shown in Table 2 below.

### (3) Evaluation of fluidity

An adhesive transfer tape was prepared as described above and stamped out with a round-edged blade to obtain a disk having an initial radius R₀ of 11.4 mm. The disk was sandwiched between a 30 mm square copper plate with a thickness of 0.5 mm and a square glass plate with a side of 30 mm and 2 mm in thickness in a manner similar to that described in the tensile shear strength test method. Then, the square glass plate and the square copper plate were heat bonded via the adhesive disk. An air press (FHAT-0006A-AAH manufactured by Honda Tsushin Kogyo Co.) was used for this heat bonding step. Conditions for the heat bonding were: temperature 120°C, force of 1470 N (3.6 MPa), press duration 30 seconds. Then, the radius R of the disk was measured using a microscope (MeasureScope 20, manufactured by Nikon Co.), and ratio of radius R after heat bonding to the initial radius R₀ (that is, R/R₀; hereinafter referred to as "fluidity") was calculated. The results are shown in Table 2.

### (4) Evaluation of solder heat resistance

An adhesive transfer tape prepared as described above was cut into 25 mm square pieces. After adhering the exposed surface of the adhesive transfer tape to a piece of polyimide film of same size and 25 µm in thickness (manufactured by DUPONT TORAY Co., trade name "Kapton^{™} V") the PET film was removed and a rolled copper foil of same size and 35 µm in thickness (manufactured by Nippon Foil Mfg Co.), was adhered to the newly exposed adhesive surface. This layup was heat bonded to provide a solder test sample. The conditions for heat bonding were: temperature 120°C, force of 1470 N (2.35 MPa), duration of press 30 seconds.

The solder test sample was placed in a thermo-hygrostatic oven at 30°C/60% RH, and aged for 1 hour, and then placed in a solder bath at 260°C for 1 minute. The solder test sample was then removed from the solder bath, and the external appearance was visually inspected for presence/absence of bubbles in the adhesive layer and separation at the interfaces of the layers of the solder test sample. When no bubbles or separation was observed, the sample was graded as "pass", that is, excellent in solder heat resistance. The results are shown in Table 2 below.

**Table 2**

| test | Example 1 | Example 2 | Example 3 | Example 3 | Example 5 | Example 6 |
|---|---|---|---|---|---|---|
| initial adhesive strength (N/cm) | 13.3 | 14.5 | 14.4 | 13.8 | 9.3 | 8.6 |
| adhesive strength after heat curing (N/cm) | 8.0 | 9.9 | 11.9 | 8.8 | 6.9 | 9.5 |
| tensile shear strength (MPa) | 11.7 | 24 | 18.5 | 16.0 | 12.4 | 14.4 |
| fluidity (%) | 5.0 | 27.6 | 22.1 | 16.4 | 3.0 | 3.0 |
| solder heat resistance | pass | Pass | pass | pass | pass | pass |

### Example 7

### Production of Heat Curable Adhesive Layer

Each of the components shown in Table 3 below were mixed in the amounts shown and then stirred at room temperature to prepare a homogeneous adhesive solution. Next, two different amounts of this adhesive solution were coated onto a substrate comprised of a silicone-treated polyethylene terephthalate (PET) film, and dried for 30 minutes in an oven at 100°C. Two PET films were obtained that were provided with heat curable adhesive layers having thicknesses of 35 µm and 7 µm, respectively.

**Table 3**

| Component | Trade Name, etc. | Parts by Weight |
|---|---|---|
| Phenoxy resin | YP50S, Kyoto Chemical, number average molecular weight: 11,800 | 30 |
| Liquid epoxy resin | DER™332, Dow Chemical Japan, epoxy equivalent: 174 | 34 |
| Caprolactone-modified epoxy resin | Placcel^{™} G-402, Daicel Chemical Industries, epoxy equivalent: 1350 | 30 |
| Methacrylate-butadiene-styrene | EXL-2691A, Rohm and Haas | 6 |
| Dicyandiamide (DICY) | CG-NA, PTI Japan | 2.9 |
| Urethane addition product (curing accelerator) | Omicure^{™} 52, PTI Japan | 1.0 |
| Methanol (MeOH) | -- | 40 |
| Methyl ethyl ketone (MEK) | -- | 90 |

### Evaluation of Adhesive Strength of Heat Curable Adhesive Layer

### -Sample Production

An adhesive transfer tape having a heat curable adhesive layer with a thickness of 35 µm was sandwiched between two pieces of rolled copper foil (size: 10 mm × 50 mm × 35 µm, Nippon Foil, trade name: SPCC-SB) in a manner similar to that described for preparation of the solder test samples. After heat bonding this layup for 60 seconds at a temperature of 120°C and load (pressure) of 25 kgf/cm² (2.5 MPa), the layup was then placed in an oven at 120°C for the times shown in Table 4 below. A total of 10 different times were evaluated.

### -Measurement of 180° Peel Strength

The cured adhesive strength of the heat curable adhesive layer was determined for each of the samples. In this example, 180° angle peel adhesion strength was measured. The measurement conditions were: room temperature (more specifically, 25°C) and a peel rate of 50 mm/min. Table 4 below shows the relationship between heat treatment time and adhesive strength.

**Table 4**

| Heat Treatment Time (min.) | 180° Peel Strength (N/cm) |
|---|---|
| 0 | 4.6 |
| 5 | 2.3 |
| 10 | 2.0 |
| 15 | 2.1 |
| 30 | 0.3 |
| 40 | 1.1 |
| 50 | 17.8 |
| 60 | 18.1 |
| 120 | 14.8 |
| 180 | 13.9 |

As shown in Table 4, the peel strength of the heat curable adhesive layer demonstrated a minimum value at a heat treatment time of about 30 minutes, and was able to increase again by further increasing the heat treatment time in the oven.

### -Production of Backing Layer and Production of Adhesive Article

After kneading Idemitsu TPO2900 and Idemitsu TPO2700 at a weight ratio of 80:20 using an extruder, the mixture was formed using a T-die into a backing layer having a thickness of 80 µm. Here, Idemitsu TPO2900 is a polyolefin-based thermoplastic elastomer containing 10% by weight of atactic polypropylene (aPP), while Idemitsu TPO2700 is a polyolefin-based thermoplastic elastomer containing 30 mol% of aPP. Thus, the backing layer produced in this example is composed of polyolefin-based thermoplastic elastomer containing 14 mol% of aPP.

Next, this backing layer was heat laminated to an adhesive transfer tape having a heat curable adhesive layer with a thickness of 7 micrometers on a PET film such that the exposed adhesive surface was placed in contact with the backing layer to produce an adhesive article. A heat laminator set at 100°C was used for the heat lamination step. Evaluation of Film Adhesive

### Evaluation (A):

The PET film was removed from the adhesive article to expose the heat curable adhesive layer. Rolled copper foil (size: 10 mm x 50 mm x 35 µm, Nippon Foil, trade name: SPCC-SB) was then heat laminated (pressure 3 MPa) at 100°C to the exposed adhesive surface. The resulting laminate was heat-treated for 90 minutes by placing it in an oven at 120°C.

Next, the backing layer of the resulting laminate was stretched by 100% (length). At this time, it was confirmed that the backing layer was separated from the adhesive layer, and that the adhesive layer had transferred to the rolled copper foil.

Subsequently, the rolled copper foil having the adhesive layer on it was placed on polyimide film having a thickness of 25 µm (Toray-Dupont, trade name: Kapton^{™} V) with the adhesive layer between the rolled copper foil and polyimide film, followed by heat bonding for 60 seconds and 120°C under a load (pressure) of 25 kgf/cm² (2.5 MPa). Subsequently, the heat bonded laminate of rolled copper foil / adhesive layer / polyimide film was placed in a 120°C oven and subjected to heat treatment for 90 minutes to obtain a test sample. When this test sample was evaluated for 180° peel strength using the procedure described above a value of 11.0 N/cm (0.1 MPa) was obtained.

### Evaluation (B):

The procedure of evaluation (A) was repeated with the following modifications. A silicon wafer measuring 8 mm in length, 5 mm in width and having a thickness of 0.4 mm was used in place of the rolled copper foil. The silicon wafer was laminated to the heat curable adhesive layer using heat bonding for 10 seconds at 100°C under a load of 1 kgf (0.1 MPa).

The silicon wafer was then cut in half, namely diced, along the direction of width together with the heat curable adhesive layer and backing layer. A diamond cutter (Buehler^{™} ISOMET^{™}) was used for the dicing step. The diced wafer article having the adhesive layer and backing layer bonded thereto was subjected to heat treatment for 30 minutes in a 120°C oven. Then the diced wafer article was removed from the oven, and after allowing to cool to room temperature, the backing layer was stretched to an elongation of 100%. It was observed that the adhesive layer was separated from the backing layer and had transferred to the diced silicon chips.

Subsequently, the resulting silicon chips were placed on a polyimide film having a thickness of 25 µm (Toray-Dupont, trade name: Kapton^{™} V) with the adhesive layer between the polyimide film and silicon chips using the same procedure as evaluation (A), followed by heat bonding for 60 seconds and 120°C under a load of 25 kgf/cm² (2.5 MPa). Subsequently, the heat bonded silicon chips / adhesive layer / polyimide film article were placed in a 120°C oven and heat treated for 90 minutes to obtain test samples. The 180° peel strength was then measured according to the same technique as described above using these test pieces. It was observed that the chips were securely adhered.

### Example 8

A uniform adhesive solution was prepared by combining each of the components having the same composition as in Example 6 and further agitating them at room temperature. Subsequently, the adhesive solution was coated to a base material of polyethylene terephthalate (PET) film treated with a silicone, and dried in a 100°C oven for 30 minutes. An adhesive transfer tape having a PET film with a heat curable adhesive layer in a thickness of 25 µm thereon was obtained. Preparation of Test Sample

The heat curable adhesive layer was bonded to a backing layer. This backing was the same as the one prepared in Example 7. The backing layer and the adhesive transfer tape were laminated using a heated roller at a temperature of 80°C and a speed of 1 meter per minute. The resulting adhesive articles were cut into circles the size of wafer (diameters of 155 mm and 220 mm) to form a set of samples. After removal of the PET film liner, the adhesive layer of the adhesive article was heat laminated to a silicon wafer having a thickness of 50 µm and diced into chips of 5 × 5mm² using a dicing apparatus manufactured by Disco Co., Ltd. (Model DFD670). After this, the backing layer was stretched by 1.6%, which was sufficient for chip pick-up, and a pick-up test was performed using Epoxy Die Bonder (equipped with a needle-less pick-up unit) manufactured by NEC Machinery, Co., Ltd.

When the wafer was diced, chips did not scatter, since the adhesive had a sufficient initial adhesive strength. Further, in the pick-up test, pick-ups were performed at chip-releasing times of 3 seconds, 0.1 second, and 0.06 second, respectively. The pick-ups were effected without any damage to the chips in all the cases.

As has been described in detail in the foregoing, according to the present invention, there is provided a heat curable adhesive composition which readily exhibits a sufficiently high initial adhesive strength before heat curing and sustaining sufficient adhesive strength after heat curing, and which is thus capable of being used especially in the manufacture of a semiconductor apparatus continuously from the dicing process to the die bonding process.

Also according to the present invention, there is provided a heat curable adhesive composition which is capable of developing a sufficiently high initial adhesive strength by heat bonding at a low temperature in a short period without suffering undesirable levels of flow-out or overflow of adhesive during heat bonding, and which maintains heat resistance and/or shear strength after heat curing.

Further, according to the present invention, there is provided a heat curable adhesive composition which does not contribute to problems such as corrosion in a semiconductor component or a semiconductor apparatus.

Also, in accordance with the present invention, there is provided an adhesive article which permits the heat curable adhesive composition of the present invention to be handled easily, and which can be advantageously used, especially in the manufacture of a semiconductor apparatus.

Further, according to the present invention, an adhesive article does not require the use of a radiating light source such as ultraviolet light for releasing the adhesive layer from the backing layer. Further, when an adhesive article with a stretchable backing layer is used as a dicing tape, a semiconductor chip having an adhesive layer thereon can be obtained easily from the adhesive article after dicing without use of a pick-up rod, since the adhesive layer is released from the backing layer at the interface between the adhesive layer and the backing layer by stretching the backing layer.

In addition, the adhesive article of the present invention can also be advantageously used in other processing fields such as the production of micro-machines in addition to dicing and die bonding.

Moreover, according to the present invention, a semiconductor component is provided which can be produced easily and in good yield. In addition, according to the present invention, semiconductor components can be produced unaccompanied by damage to semiconductor components due to the action of the adhesive article even if the semiconductor components used have a thickness of 100 µm or less.

## Claims

1. A heat curable adhesive composition comprising: a caprolactone-modified epoxy resin; and a tack reducing component that is a melamine/isocyanuric acid adduct or an organic compound that can be dissolved or dispersed with the modified epoxy resin in a solvent and has a glass transition temperature of 110°C or higher and is not decomposed or modified by heating at a temperature of 250°C or higher within a minute wherein the organic compound is selected from polyacetals, polybutylene terephthalates, polycarbonates, polyether imides, polyether sulfones, polyethylene oxides, polyphenylene sulfides, polyether ether ketones, polyarylates, polysulfones and polyamideimides.

2. A process for preparing the heat curable adhesive composition of claim 1 comprising: providing a caprolactone-modified epoxy resin; and blending therewith the tack reducing component.

3. An adhesive article comprising:
a layer of the heat curable adhesive composition according to claim 1; and
a backing layer carrying said adhesive layer on at least a portion of the backing layer.

4. A semiconductor apparatus comprising a substrate having at least one semiconductor component mounted thereon, wherein said semiconductor component is fixed to a component-mounting surface of said substrate via a layer of the heat curable adhesive composition according to claim 1.

5. The semiconductor apparatus according to Claim 4 further comprising another semiconductor component mounted to the at least one semiconductor component

6. An adhesive article comprising the heat curable adhesive composition according to claim 1 and a stretchable backing layer having an elongation of not less than 10%.

7. A process for preparing a semiconductor apparatus comprising a substrate having at least one semiconductor component mounted thereon comprising:
laminating an adhesive article on one side of a semiconductor wafer having a plurality of the semiconductor components fabricated therein, the adhesive article comprising a heat curable adhesive layer containing a caprolactone-modified epoxy resin and a tack reducing component that is a melamine/isocyanuric acid adduct or an organic compound that can be dissolved or dispersed with the modified epoxy resin in a solvent and has a glass transition temperature of 110°C or higher and is not decomposed or modified by heating at a temperature of 250°C or higher within a minute wherein the organic compound is selected from polyacetals, polybutylene terephthalates, polycarbonates, polyether imides, polyether sulfones, polyethylene oxides, polyphenylene sulfides, polyether ether ketones, polyarylates, polysulfones and polyamideimides, and a stretchable backing layer, wherein said backing layer has an elongation of not less than 10%;
discretely separating the semiconductor components maintaining the semiconductor wafer and adhesive article in a laminated state;
stretching the backing layer of the adhesive article, followed by separating the semiconductor components with the heat curable adhesive layer adhered thereto from the backing layer; and
fixing the semiconductor components to the surface of the substrate by means of the heat curable adhesive layer.

## Patentansprüche

1. Wärmehärtbare Klebstoffzusammensetzung, umfassend eine caprolactonmodifiziertes Epoxyharz; und eine klebrigkeitsvermindernde Komponente, die ein Melamin/Isocyanursäure-Addukt oder eine organische Verbindung ist, die mit dem modifizierten Epoxyharz in einem Lösungsmittel gelöst oder dispergiert werden kann und eine Glasübergangstemperatur von 110°C oder mehr hat und nicht durch einminütiges Erwärmen auf eine Temperatur von 250°C oder mehr zersetzt oder modifiziert wird, wobei die organische Verbindung aus Polyacetalen, Polybutylenterephthalaten, Polycarbonaten, Polyetherimiden, Polyethersulfonen, Polyethylenoxiden, Polyphenylensulfiden, Polyetheretherketonen, Polyarylaten, Polysulfonen und Polyamidimiden ausgewählt ist.

2. Verfahren zur Herstellung der wärmehärtbaren Klebstoffzusammensetzung nach Anspruch 1, umfassend: Bereitstellen eines caprolactonmodifizierten Epoxyharzes und Mischen der klebrigkeitsvermindernden Komponente mit diesem.

3. Klebegegenstand, umfassend:
eine Schicht der wärmehärtbaren Klebstoffzusammensetzung nach Anspruch 1; und
eine Trägerschicht, die die Klebstoffschicht auf mindestens einem Abschnitt der Trägerschicht trägt.

4. Halbleitervorrichtung, umfassend ein Substrat mit mindestens einer darauf montierten Halbleiterkomponente, wobei die Halbleiterkomponente durch eine Schicht der wärmehärtbaren Klebstoffzusammensetzung nach Anspruch 1 an einer Komponentenmontagefläche des Substrats befestigt ist.

5. Halbleitervorrichtung nach Anspruch 4, ferner umfassend eine weitere Halbleiterkomponente, die an der mindestens einen Halbleiterkomponente montiert ist.

6. Klebstoffgegenstand, umfassend die wärmehärtbare Klebstoffzusammensetzung nach Anspruch 1 und eine streckbare Trägerschicht mit einer Dehnung von nicht weniger als 10 %.

7. Verfahren zur Herstellung einer Halbleitervorrichtung, umfassend ein Substrat mit mindestens einer darauf montierten Halbleiterkomponente, umfassend:
Laminieren eines Klebegegenstands an eine Seite eines Halbleiter-Wafers mit mehreren darauf gefertigten Halbleiterkomponenten, wobei der Klebegegenstand eine wärmehärtbare Klebstoffschicht, die ein caprolactonmodifiziertes Epoxyharz und eine klebrigkeitsvermindernde Komponente enthält, die ein Melamin/Isocyanursäure-Addukt oder eine organische Verbindung ist, die mit dem modifizierten Epoxyharz in einem Lösungsmittel gelöst oder dispergiert werden kann und eine Glasübergangstemperatur von 110°C oder mehr hat und nicht durch einminütiges Erwärmen auf eine Temperatur von 250°C oder mehr zersetzt oder modifiziert wird, wobei die organische Verbindung aus Polyacetalen, Polybutylenterephthalaten, Polycarbonaten, Polyetherimiden, Polyethersulfonen, Polyethylenoxiden, Polyphenylensulfiden, Polyetheretherketonen, Polyarylaten, Polysulfonen und Polyamidimiden ausgewählt ist, und eine streckbare Trägerschicht umfasst, wobei die Trägerschicht eine Dehnung von nicht weniger als 10 % hat;
diskretes Trennen der Halbleiterkomponenten, während der Halbleiter-Wafer und der Klebegegenstand in einem laminierten Zustand gehalten werden;
Strecken der Trägerschicht des Klebegegenstands, gefolgt von Trennen der Halbleiterkomponenten mit der daran haftenden wärmehärtbaren Klebstoffschicht von der Trägerschicht; und
Befestigen der Halbleiterkomponenten an der Oberfläche des Substrats mittels der wärmehärtbaren Klebstoffschicht.

## Revendications

1. Composition adhésive thermodurcissable comprenant : une résine époxyde modifiée par de la caprolactone ;et un composant réduisant la pégosité qui est un produit d'addition mélamine/acide isocyanurique ou un composé organique qui peut être dissous ou dispersé avec la résine époxyde modifiée dans un solvant et possède une température de transition vitreuse de 110°C ou plus et n'est pas décomposé ni modifié par chauffage à une température de 250°C ou plus en une minute, le composé organique étant choisi parmi les polyacétals, les téréphtalates de polybutylène, les polycarbonates, les polyétherimides, les polyéthersulfones, les oxydes de polyéthylène, les sulfures de polyphénylène, les polyétheréthercétones, les polyarylates, les polysulfones et les polyamidimides.

2. Procédé de préparation de la composition adhésive thermodurcissable selon la revendication 1 comprenant :
la fourniture d'une résine époxyde modifiée par de la caprolactone ; et le mélange à celle-ci du composant réduisant la pégosité.

3. Article adhésif comprenant :
une couche de la composition adhésive thermodurcissable selon la revendication 1 ; et
une couche de doublage portant ladite couche adhésive sur au moins une partie de la couche de doublage.

4. Dispositif semi-conducteur comprenant un substrat ayant au moins un composant semi-conducteur monté sur celui-ci, dans lequel ledit composant semi-conducteur est fixé à une surface de montage de composants dudit substrat par l'intermédiaire d'une couche de la composition adhésive thermodurcissable selon la revendication 1.

5. Dispositif semi-conducteur selon la revendication 4 comprenant en outre un autre composant semi-conducteur monté sur le au moins un composant semi-conducteur.

6. Article adhésif comprenant la composition adhésive thermodurcissable selon la revendication 1 et une couche de doublage étirable présentant un allongement de pas moins de 10 %.

7. Procédé de préparation d'un dispositif semi-conducteur comprenant un substrat ayant au moins un composant semi-conducteur monté sur celui-ci comprenant :
le laminage d'un article adhésif sur un côté d'une tranche de semi-conducteur ayant une pluralité des composants semi-conducteurs fabriqués à l'intérieur, l'article adhésif comprenant une couche adhésive thermodurcissable contenant une résine époxyde modifiée par de la caprolactone et un composant réduisant la pégosité qui est un produit d'addition mélamine/acide isocyanurique ou un composé organique qui peut être dissous ou dispersé avec la résine époxyde modifiée dans un solvant et possède une température de transition vitreuse de 110°C ou plus et n'est pas décomposé ni modifié par chauffage à une température de 250°C ou plus en une minute, le composé organique étant choisi parmi les polyacétals, les téréphtalates de polybutylène, les polycarbonates, les polyétherimides, les polyéthersulfones, les oxydes de polyéthylène, les sulfures de polyphénylène, les polyétheréthercétones, les polyarylates, les polysulfones et les polyamidimides, et une couche de doublage étirable, dans lequel ladite couche de doublage présente un allongement de pas moins de 10 % ;
la séparation discrète des composants semi-conducteurs tout en maintenant la tranche de semi-conducteur et l'article adhésif dans un état laminé ;
l'étirage de la couche de doublage de l'article adhésif, suivi de la séparation des composants semi-conducteurs avec la couche adhésive thermodurcissable collée à ceux-ci de la couche de doublage ; et
la fixation des composants semi-conducteurs à la surface du substrat au moyen de la couche adhésive thermodurcissable.
